Europäisches Patentamt

European Patent Office

Office européen des brevets

(11) Publication number: **0 364 068**
A2

# (12) EUROPEAN PATENT APPLICATION

(21) Application number: **89305846.1**

(22) Date of filing: **09.06.89**

(51) Int. Cl.⁵: **H01L 39/24**

(30) Priority: **14.10.88 US 257918**

(43) Date of publication of application:
**18.04.90 Bulletin 90/16**

(84) Designated Contracting States:
**CH DE FR GB LI NL**

(71) Applicant: **WESTINGHOUSE ELECTRIC CORPORATION**
**Westinghouse Building Gateway Center**
**Pittsburgh Pennsylvania 15222(US)**

(72) Inventor: **Talvacchio, John Joseph**
**3621 Ridgewood Drive**
**Pittsburgh, PA 15235(US)**

(74) Representative: **van Berlyn, Ronald Gilbert**
**23, Centre Heights**
**London, NW3 6JG(GB)**

(54) Method of depositing an oxide superconductor on a substrate.

(57) Method of depositing an oxide superconductor on a substrate by epitaxially growing a 0.05-2.0 micron thick, single crystal buffer layer of magnesia or cubic zirconia on a single crystal sapphire substrate; and then growing an oriented oxide superconductor layer on the buffer layer. The sapphire substrate with a thin buffer layer provides for low dielectric losses (negligibly larger than sapphire by itself), the oxide superconductor can be oriented in a desired direction to provide higher current carrying capacity, and reaction between the sapphire substrate and the oxide superconductor (especially that due to diffusion of aluminum) is minimized. Preferably, the buffer layer is 0.1-1.0 micron thick, magnesia in a (111), or (100), or (110) orientation.

EP 0 364 068 A2

## METHOD OF DEPOSITING AN OXIDE SUPERCONDUCTOR ON A SUBSTRATE

This invention relates to a method of depositing an oxide superconductor on a substrate.

A method for preparing, and configuration of, molybdenum resistors in a superconductor integrated circuit are described in related United States Patent Application Serial No. 234,436, filed August 19, 1988. That related application uses an aluminum film over the superconductor conductors, but before the molybdenum film which is to be patterned into resistors. The aluminum film provides an aluminum-molybdenum etch stop interface (interface and aluminum film, other than under the molybdenum resistor, exposed by etching, are then rendered non-conductive by oxidization). The aluminum-molybdenum etch stop interface protects the patterned superconductor film and any other underlayers and increases processing margins for the etch time.

A superconducting digital logic amplifier for interfacing between a low voltage Josephson junction logic circuit and a higher voltage semiconductor circuit input is described in co-pending United States Patent Application Serial No. 194,688, filed May 16, 1988. That amplifier uses a first series string of at least three lower critical current Josephson junctions connected in series with an input Josephson junction to provide a series combination and a second series strings of at least four higher critical current Josephson junctions connected in parallel with the series combination to provide parallel strings having an upper common connection connected to the output terminal. By using an appropriate number of junctions in the parallel strings, a low power signal from a Josephson logic circuit is raised, by the logic amplifier, to a power appropriate to drive a conventional semiconductor circuit.

A method for preparing a superconductor integrated circuit is described in related United States Application Serial No. 234,992, filed August 22, 1988. That related application is an improved method for providing silicon dioxide with openings which expose contact pad areas for connections to superconductor in the preparation of superconducting integrated circuits. The improvement utilizes an etchant gas consisting essentially of 50-95 volume percent nitrogen trifluoride and 5-50 volume percent rare gas (preferably about 77 volume percent nitrogen trifluoride, with argon or neon or mixtures thereof as the rare gas) for the reactive ion etching of the exposed portions of the silicon dioxide film, and thus a carbon-containing etchant is not used and polymer by-products of the etching process are essentially completely avoided.

Oriented layers of the older, lower temperature superconductors have been grown on single crystal substrates. U.S. Patent Specification No. 3,816,845 (Cuomo et al.) discloses single crystal superconducting electrodes (e.g. niobium) on various substrates (e.g. sapphire). U.S. Patent Specification No. 4,768,069 (Talvacchio et al.) discloses epitaxial NbN on a substrate which is a MgO-CaO solid solution.

Oriented films of oxide superconductor have also been grown on single crystal substrates. The "best" substrates for growth of textured, high-critical-temperature oxide superconductor films have been single crystals of $SrTiO_3$ (100) or (110), followed by single-crystal MgO (100). However, the dielectric losses in these materials at microwave frequencies are high enough to be either totally unacceptable ($SrTiO_3$) or, at best, marginally un acceptable (MgO). The most desirable low-loss substrate material for most microwave applications in sapphire (single crystal -$Al_2O_3$ but the oxide superconductors react strongly with sapphire, creating a high-loss interface layer and a degraded superconductor film. The epitaxial buffer layer, e.g. 100 nm thick, single crystal MgO on sapphire by the method of this invention provides a low-loss, essentially non-reactive substrates.

The properties of the high-critical-temperature oxide superconductors are typified by those of the 92K superconductor, $YB_2Cu_3O_7$ (YBCO). The Bi-based and T1-based superconductors discovered in 1988 have not been studied as extensively as compounds of the type, rare-earth-$Ba_2Cu_3O_7$, but high processing temperatures (500° C) and reactive constituents (Ba, Sr, Ca) are present in processing these films as with YBCO.

Oriented films generally require single crystal substrates and the best oriented YBCO films have been grown on $SrTiO_3$ (100) or (110) single crystals. The merits of $SrTiO_3$ compared with other substrate materials are: (1) Less reaction between the substrate and YBCO film during the high temperature processing needed to form a crystalline film, thus there is less substrate-film reaction and interdiffusion which degrade the superconducting properties of the film and may also degrade the dielectric properties of the substrate as compared to a sapphire substrate, for example. (2) A close lattice match with YBCO (0.5% difference) and a similar Perovskite structure that promotes epitaxial film growth. Epitaxial YBCO growth results in a higher current-carrying capacity for the film-particularly if the (001) orientation is obtained.

To a less favorable extent, but for the same reasons, the next best substrate choice is MgO(100). The lattice constant of MgO is approximately 7% larger than YBCO. Sapphire is a rather poor substrate choice for oriented film growth; primarily due to film-substrate reaction, but has nevertheless been used in many laborato ries since it is inexpensive and readily available. Lower superconducting temperatures, lower current densities, and a thicker degraded layer adjacent to the substrate are characteristics of films grown directly on sapphire.

However, both $SrTiO_3$ and MgO have high dielectric losses in microwave applications as indicated below in a table of dielectric loss tangents, tan . On the basis of its tan, sapphire is an ideal substrate.

TABLE I

| Substrate | tan | Frequency |
|---|---|---|
| $SrTiO_3$ | $3 \times 10^{-2}$ | 9.5 GHZ |
| cubiz $ZrO_2$ | $2\text{-}6 \times 10^{-4}$ | independent |
| MgO | $3 \times 10^{-4}$ | independent |
| a-$Al_2O_3$ | $10^{-6}$ | independent |

Accordingly, the present invention resides in a method of depositing an oxide superconductor on a substrate characterized by epitaxially growing a 0.05-2.0 micron thick, single crystal buffer layer of magnesia or zirconia on a single crystal sapphire substrate; and growing an oriented oxide superconductor layer on said buffer layer.

The sapphire substrate with a thin buffer layer provides for low dielectric losses, the oxide superconductor can be oriented in a desired direction to provide higher current carrying capacity, and reaction between the sapphire substrate and the oxide superconductor is minimized. Preferably, the buffer layer is 0.1-1.0 micron thick, the buffer layer is of single crystal magnesia, the oxide superconductor is oriented with its c-axis normal the surface of the substrate, the sapphire substrate is 0.1-1.0 mm thick, and the magnesia is in a (111) or (100) or (110) orientation.

Single-crystal MgO films 100 nm thick have been grown on a number of orientations of sapphire substrates as shown in the table below. The MgO orientations that have not yet been identified are high-index orientations that are the least likely to be technologically useful. The (100) and the (110) orientations of MgO are the most important. The MgO was evaporated from an oxide source using an electron-beam gun in ultra-high vacuum ($10^{-9}$ torr). The sapphire substrate temperature during deposition was 800° C. The deposition rate was 0.1 nm/s.

| Sapphire Orientation | MgO Film Orientation |
|---|---|
| (11 $\overline{2}$ 0) | (111) |
| (10 $\overline{1}$ 2) | (100) |
| (10 $\overline{1}$ 0) | (110) |
| (0001) | not identified |
| (11 $\overline{2}$ 3) | not identified |

A thickness of MgO as large as approximately 1-2 m can be used to minimize the amount of Al which is able to diffuse through the buffer layer and into the YBCO film. Note that experiments performed at Stanford in which polycrystalline MgO and polycrystalline cubic zirconia buffer layers were used to separate sapphire substrates from contact with "powder pattern" (unoriented) YBCO films in an article by M. Naito et al., entitled "Thin Film Synthesis of the High-T Oxide Superconductor $YBa_2Cu_3O_7$ by Electron Beam Codeposition," J. Mater. Res., 2(6), 713-725 (1987). The 200 angstrom buffer layers of those experiments improved the film properties compared with films grown on bare sapphire but did not completely prevent Al from interdiffusing with the YBCO film. It is significant that the single-crystal microstructure of the MgO buffer layer of this invention not only promotes an epitaxial growth of the YBCO film but also significantly reduces diffusion as compared to a polycrystalline film (perhaps by eliminating the easy path of Al diffusion along grain boundaries). Thus, relatively thin buffer layers can be used which do not significantly degrade the microwave properties of the sapphire substrate.

There are a large number of microwave devices that can be made with low-loss, high-current-density, superconducting film structures capable of operation at 77K. Among these are stripline resonator filters, delay lines, directional couplers, interconnects for picosecond pulse circuits, and antennas.

As can be seen from Table I, for typical substrate thicknesses of 0.1 to 1 mm, the losses in a MgO substrate are on the margin of acceptability. However, if the thickness of the MgO buffer layer on sapphire is at least 100 times smaller than the substrate thickness, (e.g., less than 1 m) then losses from the MgO are negligible compared to the losses from sapphire. A similar argument cannot be made for $SrTiO_3$ buffer layers. They would have to be too thin to adequately prevent interdiffusion of Al into YBCO and still satisfy the criterion of negligible losses.

Table I includes data for $Y_2O_3$-stabilized cubic $ZrO_2$ (YSZ). Films grown of single-crystal YSZ substrates have properties similar to those grown on MgO (100). Therefore YSZ is as good a candidate for a buffer layer on sapphire as MgO; however, satisfactory layers of YSZ have not yet been grown epitaxially.

## Claims

1. A method of depositing an oxide superconductor on a substrate, characterized by epitaxially growing a 0.05-2.0 micron thick, single crystal buffer layer of magnesia or zirconia on a single crystal sapphire substrate; and growing an oriented oxide superconductor layer on said buffer layer.

2. A method according to claim 1, characterized in that the buffer layer is 0.1-1.0 micron thick.

3. A method according to claim 1 or 2, characterized in that the buffer layer is of single crystal magnesia.

4. A method according to claim 3, characterized in that the magnesia is in a (111) or (100) or (110) orientation.

5. A method according to claim 1, 2, 3 or 4, characterized in that the oxide superconductor is oriented with its c-axis normal the surface of the substrate.

6. A method according to any of claims 1 to 5, characterized in that the sapphire substrate is 0.1-1.0 mm thick.